# EUROPÄISCHE PATENTSCHRIFT

(11) **EP 1 023 766 B1**
(45) Veröffentlichungstag und Bekanntmachung des Hinweises auf die Patenterteilung: **11.06.2003**
(21) Anmeldenummer: 98954425.9
(22) Anmeldetag: 16.10.1998
(51) Int. Cl.: H02M 3/156, H03K 17/64

(54) **VERFAHREN UND SCHALTUNGSANORDNUNG ZUR VERRINGERUNG VON SPANNUNGSEINBRÜCHEN AUF DEN BATTERIEZULEITUNGEN**
METHOD AND CIRCUIT FOR REDUCING VOLTAGE DIPS IN BATTERY SUPPLY LINES
PROCEDE ET CIRCUIT POUR REDUIRE DES CHUTES DE TENSION DANS DES LIGNES D'ALIMENTATION DE BATTERIE

(30) Priorität: 17.10.1997 DE 19745959; 18.08.1998 DE 19837374
(43) Veröffentlichungstag der Anmeldung: 02.08.2000
(73) Patentinhaber: Continental Teves AG & Co. oHG, 60488 Frankfurt (DE)
(72) Erfinder: ENGELMANN, Mario, D-61449 Steinbach (DE); TOTH, Tibor, D-65795 Hattersheim (DE); FRITSCH, Werner, D-63322 Rödermark (DE)
(86) Internationale Anmeldenummer: EP9806566
(87) Internationale Veröffentlichungsnummer: WO99021269

(56) Entgegenhaltungen:
- EP-A- 0 849 753
- DE-A- 3 233 536
- DE-A- 3 312 108
- DE-A- 4 134 056
- DE-A- 19 808 297
- US-A- 4 504 779
- US-A- 5 739 711

## Beschreibung

Die Erfindung betrifft ein Verfahren zur Verringerung von Spannungseinbrüchen auf den Batteriezuleitungen einer Schaltungsanordnung, die zur Regelung oder Steuerung der Stromaufnahme eines Verbrauchers in einem Kraftfahrzeug dient, wobei eine Regelung oder Steuerung des Verbraucherstroms durch Pulsweitenmodulation erfolgt und ein steuerbarer Schalter verwendet wird. Eine Schaltungsanordnung zur Durchführung des Verfahrens gehört ebenfalls zur Erfindung.

Es ist bereits ein Verfahren und eine Schaltungsanordnung zur Regelung bzw. Steuerung der Stromaufnahme eines Verbrauchers in einem Kraftfahrzeug bekannt und gängig, wonach eine Regelung bzw. Steuerung der Ansteuerung eines steuerbaren Schalters in einer pulsweitenmodulierten (PWM) Regelung bzw. Steuerung erfolgt, wobei dem Verbraucher die Schaltstrecke des steuerbaren Schalters in Reihe geschaltet ist und wobei die pulsweitenmodulierte Regelung bzw. Steuerung der Stromaufnahme des Verbrauchers erfolgt, indem der Steueranschluß des steuerbaren Schalters mit einem entsprechenden Signal beaufschlagt wird. Die Regelung bzw. Steuerung der Stromaufnahme erfolgt über die Einschaltdauer des steuerbaren Schalters, der beispielsweise als Feldeffekttransistor ausgebildet sein kann. Der Verbraucher in dem Kraftfahrzeug kann beispielsweise ein Booster, ein Magnetventil oder ein sonstiger Verbraucher sein.

In der US-A-4,504,779 ist ein Schältnetzteil beschrieben, bei dem die Stromänderungsgeschwindigkeit geändert wird, um zum Beispiel EMI-Probleme zu überwinden. Dabei wird mit Hilfe der elektronischen Schaltung die Spannung für einen Verbraucher gesteuert, indem das Eingangssignal und die Steuerspannungen für ein oberes Limit und ein unteres Limit für einen steuerbaren Schalter gesteuert werden. Ferner ist in der DE-A-41 34 056 ein Verfahren zur redundanten Steuerung eines Stromreglers offenbart.

Der vorliegenden Erfindung liegt die Aufgabe zugrunde, Spannungseinbrüche auf Batteriezuleitungen, die z.B. auf das Schalten von Strömen bei einer Regelung mit Hilfe einer Pulsweitenmodulation zurückgehen und die Störstrahlung hervorrufen können, auf ein Minimum zu reduziern.

Diese Aufgabe wird erfindungsgemäß nach Anspruch 1 gelöst, dessen Besonderheit darin besteht, daß eine die Schaltflanken eines pulsweitenmodulierten Signals beeinflussende Schaltung verwendet wird, daß ein die Änderung des Stromes in den Batteriezuleitungen zu dem Verbraucher repräsentierendes Signal gewonnen und dem Eingangssignal der Schaltung gegengekoppelt wird.

Indem der Stromverlauf in den Batteriezuleitungen verbessert wird, wird die ausgesendete Störstrahlung verringert. Es ist dann möglich, zur Stützung der Batteriespannung einen sehr viel kleineren Elektrolytkondensator zu verwenden. Weiterhin ergibt sich eine Verbesserung des Signalverlaufes des durch den Verbraucher fließenden Stromes.

Der Widerstand des steuerbaren Schalters ändert sich nicht schlagartig sondern innerhalb einer gewissen Zeitspanne. Diese Zeitspanne ist vergleichsweise kurz bemessen und hängt von der Größe des Ansteuersignales ab. Bei einem starken Ansteuersignal (Strom oder Spannung) ändert sich der Widerstand des steuerbaren Schalters sehr schnell. Es kann dann beim Einund beim Ausschalten zu Stromstößen kommen. Vorteilhaft wird daher bei dem Verfahren nach Patentanspruch 1 die Stärke des Ansteuersignales in Abhängigkeit von der zeitlichen Änderung des Stromes variiert. Beim Einschalten wird also dem Ansteuersignal die positive Änderung des Stromes gegengekoppelt, so daß das Ansteuersignal reduziert wird. Die Zeitspanne, innerhalb der der steuerbare Schalter leitend wird, wird daher verlängert. Beim Ausschalten wird dem Ansteuersignal die negative Änderung des Stromes gegengekoppelt. Der Abfall des Ansteuersignales wird daher reduziert. Die Zeitspanne, innerhalb der der steuerbare Schalter von dem leitenden Zustand in den gesperrten Zustand übergeht, wird daher verlängert.

Bei dem Verfahren nach Anspruch 2 wird das den Strom in den Batterizuleitungen zu dem Verbraucher repräsentierende Signal mittels eines Shunt-Widerstandes ermittelt wird.

Da die Stromflanke in den Zuleitungen geregelt werden soll, kann mittels dieses Widerstandes eine von diesem Strom abgeleitete Größe zum Gegenkoppeln herangezogen werden. Ein auf Masse bezogener Strom-Meßwiderstand ist die billigste Lösung.

Bei dem Verfahren nach Anspruch 3 ist der Verbraucher ein induktiver Verbraucher. Zu dem Ansteuersignal wird zusätzlich ein die Änderung des Spannungsabfalls über dem induktiven Verbraucher repräsentierendes Signal gegengekoppelt.

Beim Ausschalten des steuerbaren Schalters kommt vor der zu regelnden Stromflanke die Spannungsflanke, deren Überwindung die Stromregelung in die Übersteuerung treibt. Kommt dann die Stromflanke, muß die Regelung aus der Übersteuerung heraus zurück in den Arbeitsbereich, was eine nicht vernachlässigbare Zeit dauert. Dies wird vorteilhaft durch die Maßnahmen nach Anspruch 3 vermieden.

Als weitere Lösung der Aufgabe wird gemäß Anspruch 4 eine Schaltungsanordnung zur Durchführung des erfindungsgemäßen Verfahrens vorgeschlagen, die eine Schaltung zur Beeinflussung der Schaltflanken eines pulsweitenmodulierten Signals enthält, mit der ein Signal, das die Änderung des Stromes in den Batteriezuleitungen zu dem Verbraucher repräsentiert, gewonnen und dem Eingangssignal der Schaltung gegengekoppelt wird, indem das Signal, das den Strom in den Batteriezuleitungen repräsentiert, dem Eingangssignal der Schaltung über einen Kondensator zugeführt wird.

Dabei wird ohne großen schaltungstechnischen Aufwand, nämlich durch die Verwendung des Kondensators, erreicht, daß die zeitliche Änderung des Signals erfaßt und zurückgeführt werden kann.

Bei der Schaltungsanordnung nach Anspruch 5 wird das den von dem Verbraucher aufgenommenen Strom repräsentierende Signal mittels eines Shunt-Widerstandes ermittelt.

Bei der Schaltungsanordhung nach Anspruch 6 ist der Verbraucher ein induktiver Verbraucher und dem Ansteuersignal wird zusätzlich ein die Änderung des Spannungsabfalls über dem induktiven Verbraucher repräsentierendes Signal gegengekoppelt, indem das den Spannungsabfall über dem induktiven Verbraucher repräsentierende Signal dem Eingangssignal der Schaltung über einen Kondensator zugeführt wird.

Dies erweist sich insofern als vorteilhaft, als unmittelbar bei Beginn eines Schaltvorganges noch keine Stromänderung vorliegt. Es wird dem Ansteuersignal keine Korrekturgröße gegengekoppelt. Es kann also gerade unmittelbar beim Ein- bzw. Ausschalten zu kleineren Stromstößen kommen. Vorteilhaft wird die Änderung des Spannungsabfalles über dem induktiven Verbraucher zusätzlich gegengekoppelt. Der Spannungsabfall über dem induktiven Verbraucher wird nach dem Induktionsgesetz im wesentlichen durch die zeitliche Änderung des Stromes bestimmt.

Indem also die zeitliche Änderung des Spannungsabfalles gegengekoppelt wird, entspricht dies einer Gegenkopplung eines Signals, das die zweite zeitliche Ableitung des Stromes repräsentiert. Das Ansteuersignal kann also bezüglich Stromänderungen sehr schnell variiert werden.

Ein Ausführungsbeispiel der Erfindung ist in der Zeichnung dargestellt. Es zeigt dabei im einzelnen:
- Fig. 1:: eine Schaltungsanordnung,
- Fig. 2:: ein weiteres Ausführungsbeispiel einer Schaltungsanordnung,
- Fig. 3:: Signalverläufe des Stromes ohne Gegenkopplung,
- Fig. 4:: Signalverläufe des Stromes mit Gegenkopplung
- Fig. 5:: einen Ausschnitt aus dem Signalverlauf der Figur 3
und
- Fig. 6:: den Ausschnitt aus dem Signalverlauf der Figur bei verbesserter Gegenkopplung.

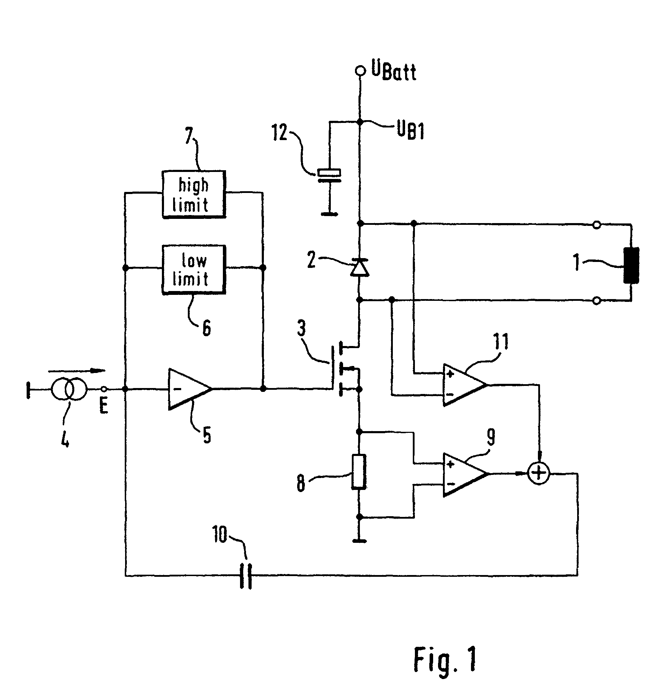

Figur 1 zeigt eine Schaltung zur Verringerung von Spannungseinbrüchen bei einer pulsweitenmodulierten Regelung bzw. Steuerung der Stromaufnahme eines Verbrauchers 1 in einem Kraftfahrzeug. Dieser Verbraucher 1 kann beispielsweise die Spule eines Magnetventiles in einer Bremsanlage eines Kraftfahrzeuges sein. Diesem Verbraucher 1 ist eine Schottky-Diode 2 als Freilaufdiode parallel geschaltet, damit der in dem induktiven Verbaucher 1 beim Abschalten induzierte Strom weiterfließen kann.
Weiterhin ist ein steuerbarer Schalter 3 zu sehen, der in der Schaltungsanordnung nach Figur 1 ein Feldeffekttransistor ist.

Dieser Feldeffekttransistor 3 wird in der Schaltungsanordnung nach Figur 1 mittels einer Stromquelle 4 angesteuert. Der von dieser Stromquelle in das Gate des Feldeffekttransistors 3 fließende Strom verursacht aufgrund kapazitiver Effekte eine Spannung zwischen Gate und Drain, so daß der Feldeffekttransistor 3 leitend wird. Der von der Stromquelle 4 gelieferte Strom fließt während der Flanken über den Kondensator, ansonsten über die Begrenzer 6 und 7, abhängig davon, ob der Verbraucher 1 gerade ein- oder ausgeschaltet ist. Die Begrenzer 6 und 7 sind Mittel, die eine obere und untere Grenze des Stromes definieren. Sie sorgen dafür, daß am Ende der Flanke der Strom von der Stromquelle 4 abfließt und den Kondensator 10 nicht weiter laden bzw. entladen kann. Dadurch bleibt der Inverter 5 immer im linearen Bereich und die Regelung spricht bei der nächsten Flanke unmittelbar schnell wieder an.

Über die Ansteuerung des Feldeffekttransistors 3 wird die Einschaltdauer dieses Feldeffekttransistors 3 und damit die Stromaufnahme des Verbrauchers 1 gesteuert bzw. geregelt.

Weiterhin ist der Schaltung nach Figur 1 zu entnehmen, daß ein Shunt-Widerstand 8 vorhanden ist. Die über diesem Shunt 8 abfallende Spannung wird mittels eines Verstärkers 9 gemessen und über einen Kondensator 10 dem Eingang der Schaltung gegengekoppelt.

Darüber hinaus hat es sich als vorteilhaft erwiesen, die über dem induktiven Verbraucher 1 abfallende Spannung mittels eines weiteren Verstärkers 11 zu erfassen und dem Eingangssignal E ebenfalls über den Kondensator gegenzukoppeln.
Damit lassen sich hohe Stromänderungen bzw. steile Schaltflanken unmittelbar zu Beginn der Einschaltphasen sowie zu Beginn der Ausschaltphasen vermeiden.

Zum Glätten der Batteriespannung U_{Batt} auf den Zuleitungen ist weiterhin ein Elektrolytkondensator 12 vorgesehen. Es erweist sich als vorteilhaft, daß durch den Einsatz der erfindungsgemäßen Schaltung, die die Schaltflanken abflacht, ein relativ kleiner Elektrolytkondensator genügt.

Es ist selbstverständlich möglich, die Signale der Verstärker 9 und 11 über verschiedene Kondensatoren gegenzukoppeln. Damit läßt sich die Stärke der Gegenkopplung der beiden Signale unterschiedlich einstellen. Bei Verwendung eines größeren Kondensators erfolgt eine entsprechend stärkere Gegenkopplung, was in flacheren Flanken im Stromverlauf resultiert, während bei Verwendung kleinerer Kondensatoren der Stromverlauf entsprechend steiler ist.

Ebenso können verschiedene Gegenkopplungsgrade durch verschiedene Verstärkungen der Verstärker 9 und 11 abgedeckt werden.

Bei einer Realisierung durch eine integrierte Schaltung macht man den Kondensator so klein wie möglich.

Außer der Größe des Kondensators 10 geht natürlich auch der Stromverlauf selbst in die Regelung ein. Ändert sich das Stromsignal im Shunt-Widerstand 8 sehr schnell, so wird bedingt durch die differentielle Wirkung des Kondensators 10 entsprechend stärker gegengekoppelt als bei einem flacheren Stromverlauf.

Der Grad der Gegenkopplung bzw. Stromflankensteilheit wird durch die Werte des Kondensators 10 in Kombination mit dem von der Gate-Ansteuerung zur Verfügung gestellten Strom I definiert.

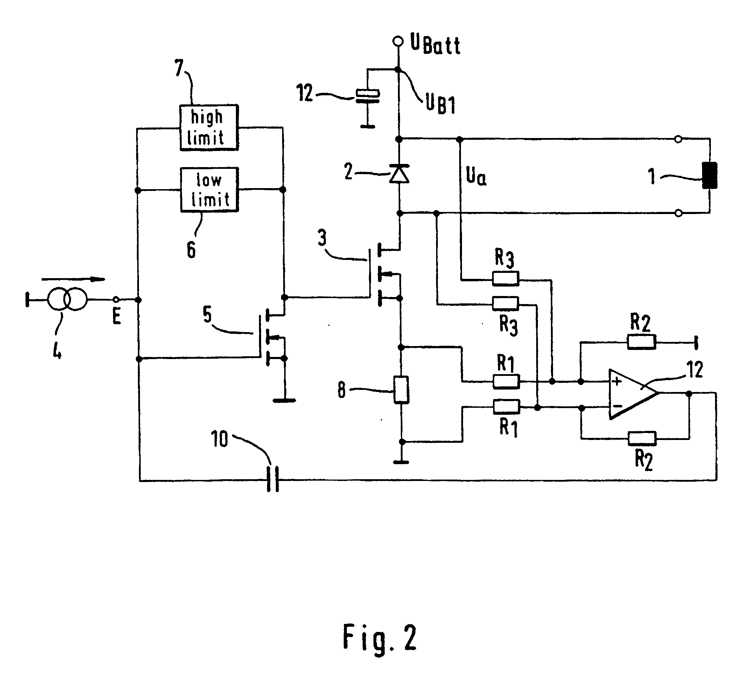

Eine weitere vorteilhafte Ausgestaltung der Schaltungsanordnung ergibt sich gemäß Figur 2, wenn man den Summationspunkt vor die Verstärker zieht. Es zeigt sich dabei, daß einer der Verstärker entfallen kann. Es verbleibt dann nur noch der Verstärker 12. Unterschiedliche Gegenkopplungsgrade lassen sich hierbei durch unterschiedliche Gewichtung im Summationspunkt erreichen. Der Inverter 5 ist hier ebenfalls als Feldeffekttransistor ausgeführt.

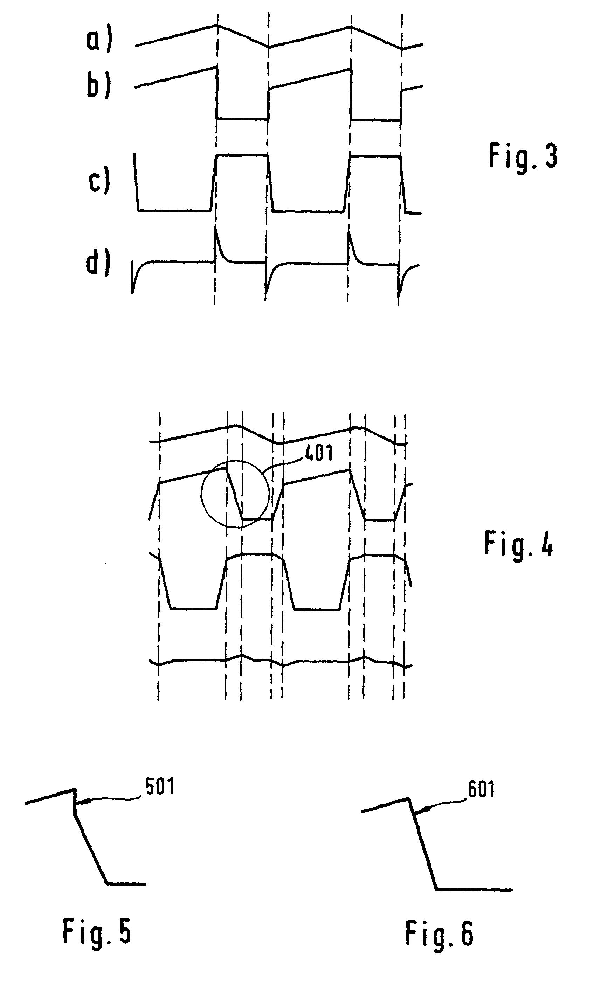

Figuren 3a bis 3d sowie die Figuren 4a bis 4d zeigen jeweils übereinander
a) den Verlauf des Stromes im Verbraucher 1, der im vorliegenden Fall eine Spule ist,
b) den Strom in der Zuleitung zu dem Verbraucher 1 und damit auch im Shunt-Widerstand 8,
c) Die Drain-Spannung am Feldeffekttransistor 3 und
d) die Betriebsspannung der Schaltung hinter den Zuleitungen (UB1).

In den Darstellungen nach den Figuren 3a bis 3d sind die Verhältnisse ohne die erfindungsgemäße Gegenkopplung dargestellt, in Figuren 4a bis 4d sind die Verhältnisse mit der Gegenkopplung des am Shunt-Widerstand 8 gemessenen Signals gezeigt.

Es zeigt sich dabei, daß durch die Gegenkopplung die Steilheit der Stromflanken sowie der Spannungsflanken in der Zuleitung deutlich reduziert ist.

Zur Begrenzung der steilen Flanken kann beispielsweise der Elektrolytkondensator 12 vorgesehen werden.

Figur 5 zeigt in vergrößerter Darstellung den Ausschnitt 401 der Figur 4. Die Ausschnittvergrößerung der Stromausschaltflanke zeigt im ersten Moment eine noch sehr schnelle Stromänderung 501. Diese kleine Stufe in der Stromfunktion ist noch deutlicher im Hochfrequenzstörspektrum zu sehen. Die Begründung dieser Stufe liegt an der im ersten Moment nicht ausreichenden Gegenkopplung des Verstärkers 9, der den Strom im Shunt-Widerstand 8 erfaßt. Der Grund hierfür ist der vorher in Sättigung getriebene Regelkreis.

Deswegen wird vorteilhaft der weitere Verstärker 11 vorgesehen. Mittels dieses Verstärkers wird die Spannung über dem Verbraucher 1 erfaßt und differentiell gegengekoppelt. Da es sich um einen induktiven Verbraucher handelt, ist die Spannung der Stromänderung proportional. Da dieses Signal wiederum differentiell gegengekoppelt wird, wird ein der zweiten Ableitung des Stromes nach der Zeit entsprechendes Signal gegengekoppelt, wodurch eine schnelle Reaktionszeit der Regelung gewährleistet wird. Insgesamt wird also schneller bemerkt, daß der Stromfluß unterbrochen wird und der Feldeffekttransistor 3 abschaltet. Weiterhin steht ein hinreichend großer Signalhub zur Verfügung, um die notwendige Korrekturgröße im Gatesteuerstrom I erfolgen zu lassen.

Die Ausführungen zu den Verstärkern 9 und 11 gelten entsprechend für die Ansteuerungen des Verstärkers 12 nach Figur 2.

Figur 6 zeigt den entsprechenden Abschnitt, bei dem an der Stelle 601 zu sehen ist, daß die steile Flanke im Stromverlauf verschwunden ist.

Man kann in der gezeigten Schaltungsanordnung auf den Verstärker 11 verzichten, muß dann aber die gezeichnete "Treppenstufe" in Kauf nehmen. Wenn man den Kondensator 10 groß genug dimensionieren kann (beispielsweise bei einer Realisierung in diskreter Schaltungstechnik), kann man dann auch auf Verstärker 9 verzichten, indem man den Kondensator 10 direkt an den Strommeßwiderstand 8 anschließt.

## Patentansprüche

1. Verfahren zur Verringerung von Spannungseinbrüchen auf den Batteriezuleitungen einer Schaltungsanordnung, die zur Regelung der Stromaufnahme eines Verbrauchers (1) in einem Kraftfahrzeug dient, wobei eine Regelung oder Steuerung des Verbraucherstroms durch Pulsweitenmodulation (PWM) erfolgt und ein steuerbarer Schalter (3) verwendet wird,
**dadurch gekennzeichnet,**
**daß** eine die Schaltflanken des pulsweitenmodulierten Signals beeinflussende Schaltung verwendet wird,
**daß** ein die Änderung des Stromes in den Batteriezuleitungen zu dem Verbraucher (1) repräsentierendes Signal an einem Shunt-Widerstand (8), einem Verstärker (9) und/oder einem Elektrolytkondensator (12) gewonnen und dem Ansteuersignal (E) des Schalters (3) gegengekoppelt wird, wobei beim Einschalten dem Ansteuersignal (E) des Schalters (3) die positive Änderung des Stromes gegengekoppelt wird und beim Ausschalten dem Ansteuersignal (E) des Schalters (3) die negative Änderung des Stromes gegengekoppelt wird.

2. Verfahren nach Anspruch 1,
**dadurch gekennzeichnet,**
**daß** das den Strom in den Batterizuleitungen zu dem Verbraucher (1) repräsentierende Signal durch den Shunt-Widerstand (8) ermittelt wird.

3. Verfahren nach Anspruch 1 oder 2,
**dadurch gekennzeichnet,**
**daß** der Verbraucher (1) ein induktiver Verbraucher ist und daß dem Ansteuersignal (E) des Schalters (3) zusätzlich ein die Änderung des Spannungsabfalls über dem induktiven Verbraucher (1) repräsentierendes Signal an einem Verstärker (11) und/oder dem Elektrolytkondensator (12) gegengekoppelt wird.

4. Schaltungsanordnung zur Durchführung des Verfahrens nach einem oder mehreren der Ansprüche 1 bis 3, welche Schaltungsanordnung zur Regelung der Stromaufnahme eines Verbrauchers (1) in einem Kraftfahrzeug dient, wobei eine Regelung oder Steuerung des Verbraucherstroms durch Pulsweitenmodulation (PWM) erfolgt und ein steuerbarer Schalter (3) verwendet wird,
**dadurch gekennzeichnet,**
**daß** die Schaltungsanordnung eine Schaltung zur Beeinflussung der Schaltflanken eines pulsweitenmodulierten Signals enthält, mit der ein Signal, das die Änderung des Stromes in den Batteriezuleitungen zu dem Verbraucher (1) repräsentiert, gewonnen wird an einem Shunt-Widerstand (8), einem Verstärker (9) und/oder einem Elektrolytkondensator (12),
**daß** die Schaltung Leitungen aufweist, zur Gegenkopplung des Signals an dem Shunt-Widerstand (8), dem Verstärker (9) und/oder dem Elektrolytkondensator (12) mit dem Ansteuersignal (E) des Schalters (3),
**daß** die Schaltung Mittel aufweist, mit deren Hilfe beim Einschalten dem Ansteuersignal (E) des Schalters (3) die positive Änderung des Stromes gegengekoppelt wird und beim Ausschalten dem Ansteuersignal (E) des Schalters (3) die negative Änderung des Stromes gegengekoppelt wird,
und **daß** die Schaltungsanordnung einen Kondensator (10) aufweist, über welchen Kondensator (10) das Signal an dem Shunt-Widerstand (8), dem Verstärker (9) und/oder dem Elektrolytkondensator (12) dem Ansteuersignal (E) des Schalters (3) zugeführt wird.

5. Schaltungsanordnung nach Anspruch 4,
**dadurch gekennzeichnet,**
**daß** das von dem Verbraucher (1) aufgenommenen Strom repräsentierende Signal durch den Shunt-Widerstand (8) ermittelt wird.

6. Schaltungsanordnung nach Anspruch 4 oder 5,
**dadurch gekennzeichnet,**
**daß** der Verbraucher (1) ein induktiver Verbraucher ist und daß diese Leitungenen aufweist, zur zusätzlichen Gegenkopplung eines die Änderung des Spannungsabfalls über dem induktiven Verbraucher (1) repräsentierenden Signales an einem Verstärker (11) und/oder dem Elektrolytkondensator (12) mit dem Ansteuersignal (E) des Schalters (3), indem die Schaltungsanordnung einen Kondensator (10) aufweist, über welchen Kondensator (10) das den Spannungsabfall über dem induktiven Verbraucher (1) repräsentierende Signal an dem Verstärker (11) und/oder dem Elektrolytkondensator (12) dem Ansteuersignal (E) des Schalters (3) zugeführt wird.

## Claims

1. Method of reducing voltage sags in the battery supply lines of a circuit arrangement which is used to regulate the current input of a consumer (1) in an automotive vehicle, wherein the consumer current is regulated or controlled by pulse-width modulation (PWM) and a controllable switch (3) is used,
**characterized in that** a circuit is used which influences the edges of a pulse-width modulated signal, **in that** a signal which is representative of the variation of the current in the battery supply lines to the consumer (1) is produced at a shunt resistor (8), an amplifier (9), and/or an electrolytic capacitor (12) and fed back to the actuation signal (E) of the switch (3), wherein upon switching-on of the actuation signal (E) of the switch (3) the positive change in the current is fed back and upon switching-off of the actuation signal (E) of the switch (3) the negative change in the current is fed back.

2. Method as claimed in claim 1,
**characterized in that** the signal which is representative of the current in the battery supply lines to the consumer (1) is determined by means of the shunt resistor (8).

3. Method as claimed in claim 1 or 2,
**characterized in that** the consumer (1) is an inductive consumer, and **in that**, in addition, a signal at the amplifier (11) and/or the electrolytic capacitor (12) which is representative of the change in the voltage drop across the inductive consumer (1) is fed back to the actuation signal (E) of the switch (3).

4. Circuit arrangement for implementing the method as claimed in any one or more of claims 1 to 3, which arrangement which is used to regulate the current input of a consumer (1) in an automotive vehicle, wherein the consumer current is regulated or controlled by pulse-width modulation (PWM) and a controllable switch (3) is used,
**characterized in that** the circuit arrangement includes a circuit for influencing the edges of a pulse-width modulated signal, by which circuit a signal which is representative of the change in the current in the battery supply lines to the consumer (1) is produced at a shunt resistor (8), an amplifier (9), and/or an electrolytic capacitor (12), **in that** the said circuit includes lines for feeding back the signal at the shunt resistor (8), the amplifier (9), and/or the electrolytic capacitor (12) to the actuation signal (E) of the switch (3), **in that** the said circuit includes means by way of which, upon switching-on of the actuation signal (E) of the switch (3), the positive change in the current is fed back and, upon switching-off, the negative change in the current is fed back to the actuation signal (E) of the switch (3), and **in that** the circuit arrangement includes a capacitor (10) by which capacitor (10) the signal at the shunt resistor (8), the amplifier (9), and/or the electrolytic capacitor (12) is sent to the actuation signal (E) of the switch (3).

5. Circuit arrangement as claimed in claim 4,
**characterized in that** the signal representative of the current received by the consumer (1) is determined by the shunt resistor (8).

6. Circuit arrangement as claimed in claim 4 or 5,
**characterized in that** the consumer (1) is an inductive consumer, and **in that** the circuit arrangement includes lines for the additional feeding back of a signal at an amplifier (11) and/or the electrolytic capacitor (12) to the actuation signal (E) of the switch (3), the said signal being representative of the change in the voltage drop across the inductive consumer (1), with the circuit arrangement including a capacitor (10) by way of which capacitor (10) the signal at the amplifier (11) and/or the electrolytic capacitor (12) which is representative of the voltage drop across the inductive consumer (1), is sent to the actuation signal (E) of the switch (3).

## Revendications

1. Procédé pour réduire des chutes de tension dans les lignes d'alimentation de batterie d'un montage électrique qui sert à réguler la consommation de courant d'un utilisateur (1) dans un véhicule automobile, une régulation ou une commande du courant utilisateur s'effectuant par modulation d'impulsions en durée (MID) et un commutateur asservissable (3) étant utilisé.
**caractérisé en ce qu'**on utilise un circuit agissant sur les flancs de commutation du signal à modulation d'impulsions en durée,
et **en ce qu'**on obtient, sur une résistance shunt (8), un amplificateur (9) et/ou un condensateur électrolytique (12), un signal représentatif de la modification du courant dans les lignes d'alimentation de batterie menant à l'utilisateur (1), et on le réinjecte en contre-réaction au signal d'asservissement (E) du commutateur (3), la modification positive du courant étant réinjectée en contre-réaction au signal d'asservissement (E) du commutateur (3) lors de l'activation, et la modification négative du courant étant réinjectée en contre-réaction au signal d'asservissement (E) du commutateur (3) lors de la désactivation.

2. Procédé selon la revendication 1, **caractérisé en ce que** le signal représentatif du courant dans les lignes d'alimentation de batterie menant à l'utilisateur (1) est déterminé par la résistance shunt (8).

3. Procédé selon la revendication 1 ou 2, **caractérisé en ce que** l'utilisateur (1) est un utilisateur inductif, et **en ce qu'**un signal représentatif de la modification de la chute de tension sur l'utilisateur inductif (1), obtenu sur un amplificateur (11) et/ou sur le condensateur électrolytique (12), est réinjecté en supplément en contre-réaction au signal d'asservissement (E) du commutateur (3).

4. Montage électrique pour la mise en oeuvre du procédé suivant une ou plusieurs des revendications 1 à 3, montage qui sert à réguler la consommation de courant d'un utilisateur (1) dans un véhicule automobile, la régulation ou la commande du courant de l' utilisateur s'effectuant par modulation d'impulsions en durée (MID) et un commutateur asservissable (3) étant utilisé,
**caractérisé en ce que** le montage électrique contient un circuit pour agir sur les flancs de commutation d'un signal à modulation d'impulsions en durée, circuit avec lequel on obtient, sur une résistance shunt (8), un amplificateur (9) et/ou un condensateur électrolytique (12), un signal représentatif de la modification du courant dans les lignes d'alimentation de batterie menant à l'utilisateur (1), **en ce que** le circuit présente des lignes pour que le signal obtenu sur la résistance shunt (8), l'amplificateur (9) et/ou le condensateur électrolytique (12) soit réinjecté en contre-réaction au signal d'asservissement (E) du commutateur (3),
**en ce que** le circuit présente des moyens à l'aide desquels la modification positive du courant est réinjectée en contre-réaction au signal d'asservissement (E) du commutateur (3) lors de l'activation, et la modification négative du courant est réinjectée en contre-réaction au signal d'asservissement (E) du commutateur (3) lors de la désactivation,
et **en ce que** le montage électrique présente un condensateur (10) par l'intermédiaire duquel le signal obtenu sur la résistance shunt (8), l'amplificateur (9) et/ou le condensateur électrolytique (12) est apporté au signal d'asservissement (E) du commutateur (3).

5. Montage électrique selon la revendication 4, **caractérisé en ce que** le signal représentatif du courant consommé par l'utilisateur (1) est déterminé par la résistance shunt (8).

6. Montage électrique selon la revendication 4 ou 5, **caractérisé en ce que** l'utilisateur (1) est un utilisateur inductif, et **en ce que** ce montage électrique présente des lignes pour réinjecter en supplément en contre-réaction au signal d'asservissement (E) du commutateur (3) un signal représentatif de la modification de la chute de tension sur l'utilisateur inductif (1), obtenu sur un amplificateur (11) et/ou sur le condensateur électrolytique (12), par le fait que le montage électrique présente un condensateur (10) par l'intermédiaire duquel le signal représentatif de la chute de tension sur l'utilisateur inductif (1), obtenu sur l'amplificateur (11) et/ou sur le condensateur électrolytique (12), est apporté au signal d'asservissement (E) du commutateur (3).
